Europäisches Patentamt

(19) European Patent Office

Office européen des brevets

(11) Numéro de publication: **0 157 991**

**A1**

(12) **DEMANDE DE BREVET EUROPEEN**

(21) Numéro de dépôt: **84810175.4**

(22) Date de dépôt: **10.04.84**

(51) Int. Cl.⁴: **C 23 C 14/56**
//C23C14/34

(43) Date de publication de la demande:
**16.10.85 Bulletin 85/42**

(84) Etats contractants désignés:
**AT BE CH DE FR GB IT LI NL SE**

(71) Demandeur: **INTERPATENT ANSTALT (INDELEC Abteilung)**
**Grande Rue**
**FL-9490 VADUZ(LI)**

(72) Inventeur: **Croisier, Jean-Paul**
**1, rue Céard**
**CH-1204 Geneve(CH)**

(74) Mandataire: **Kovacs, Paul et al,**
**WILLIAM BLANC & CIE Conseils en propriété Industrielle**
**S.A. Place du Molard 5**
**CH-1204 Genève(CH)**

(54) **Dispositif pour effectuer en continu la métallisation sélective de pièces industrielles, notamment en électronique.**

(57) L'invention concerne la fabrication de pièces métallisées, notamment pour l'industrie électronique.

Les pièces sont juxtaposées dans une bande (8) qui défile de l'une à l'autre des deux bobines (3) et (2), à l'intérieur d'une cassette étanche à vide (1). La métallisation est assurée par le poste (11) avec cathode à magnétron.

Application: métallisation sélective à cadence industrielle.

FIG 1

EP 0 157 991 A1

1

La présente invention est relative à un procédé et à un dispositif nouveaux permettant d'effectuer en continu et de façon sélective, la métallisation superficielle de pièces industrielles.

On sait que dans de nombreuses applications industrielles, et notamment dans les industries de pointe (électronique, chimie-physique, techniques nucléaires, etc.), on est amené à fabriquer des pièces industrielles à revêtir localement d'une couche métallique. Il est important que cette métallisation puisse être effectuée de façon sélective, c'est-à-dire sur des zones à contours exactement délimités, et ceci notamment pour les deux raisons suivantes :

     - d'une part la précision du contour à métalliser est parfois importante pour le bon fonctionnement ultérieur du produit (cas des supports de circuits intégrés, de microprocesseurs, et de transistors ; cas plus généralement dans l'industrie de la connexion ou de l'électronique) ;

     - d'autre part, la métallisation consistant généralement à déposer une couche d'un métal précieux (or, argent, platine, rhodium, etc.), des raisons évidentes d'économie conduisent à n'effectuer le dépôt que sur des zones où il est effectivement nécessaire.

Les procédés actuellement connus pour effectuer une métallisation sélective de pièces industrielles présentent généralement l'inconvénient de ne pas pouvoir être mis en oeuvre à la continue. Autrement dit, les pièces sont métallisées d'une après l'autre et il en résulte un prix de revient relativement élevé.

La présente invention a pour but d'éviter ces inconvénients en réalisant à la continue la métallisation sélective de pièces industrielles suivant un procédé nouveau qui, d'une part réduit le coût de fabrication, d'autre part garantit une excellente fiabilité lors de sa mise en oeuvre à l'échelle industrielle.

Un dispositif selon l'invention pour effectuer à la continue une métallisation sélective sur des pièces industrielles est caractérisé en ce qu'il comprend :

     - une bande souple continue sur laquelle les pièces à traiter sont disposées les unes à la suite des autres;

- une bobine d'alimentation sur laquelle est enroulée la bande des pièces à traiter ;

- un poste de métallisation sous vide avec cathode à magnétron à travers lequel peut circuler la bande ;

- une bobine de stockage sur laquelle vient s'enrouler la bande après traitement ;

- une cassette étanche contenant les deux bobines, la bande et le poste de métallisation avec cathode à magnétron ;

- les moyens pour maintenir à l'intérieur de la cassette un vide inférieur à 1/10 de millimètre de mercure ;

- des moyens pour entraîner en rotation les deux bobines de façon à faire circuler la bande à travers le poste de métallisation, en l'enroulant sur la bobine de stockage tandis qu'elle se déroule de la bobine d'alimentation.

Suivant une autre caractéristique de l'invention, le poste de métallisation comporte une anode métallique formée du métal à déposer sur les pièces, la bande défilant entre cette anode et une cathode entre lesquelles règne une tension électrique continue, un masque découpé selon le contour à métalliser étant intercalé entre la bande et l'anode.

Suivant une autre caractéristique de l'invention, la bande souple est métallique, les pièces à métalliser étant directement découpées dans le métal de la bande tout en restant liées les unes aux autres.

Suivant une autre caractéristique de l'invention, les moyens prévus pour l'entraînement des deux bobines leur communiquent un mouvement saccadé, synchronisé avec les moyens créant la tension électrique entre l'anode et la cathode, à savoir :

- la tension électrique du magnétron est coupée pendant chaque phase d'avancement de la bande par rotation des bobines ;

- au contraire, cette tension est rétablie pendant chaque phase d'arrêt de la bande et des bobines.

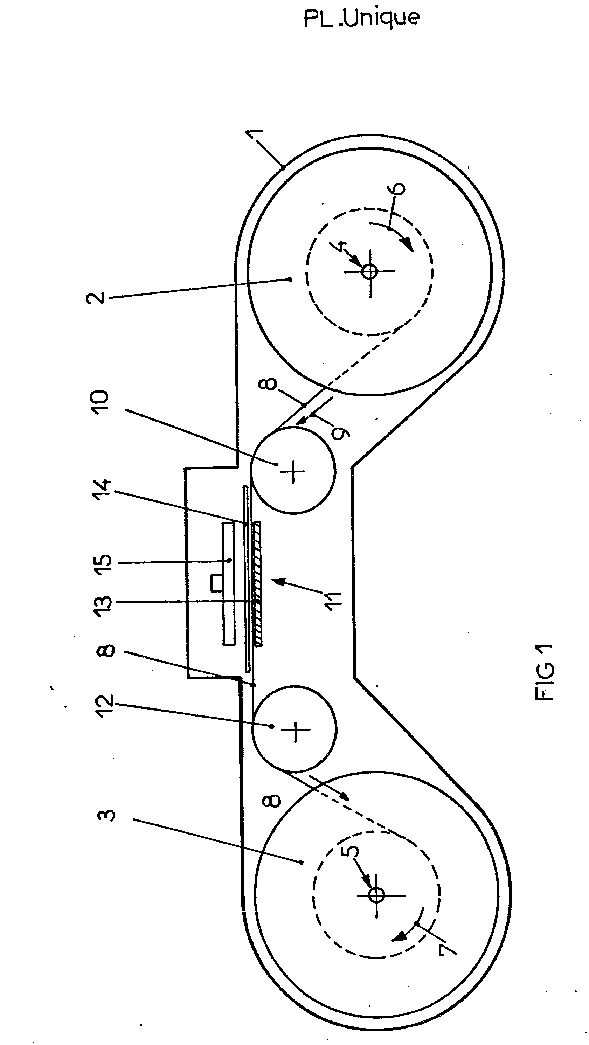

Sur le dessin annexé, la figure unique montre schématiquement la structure d'une cassette selon l'invention pour effectuer en continu une métallisation sous vide sélective.

3

On a désigné pour la référence 1 une enveloppe étanche, rigide et qui définit une cassette plate à l'intérieur de laquelle deux bobines 2 et 3 peuvent tourner autour de leur axe respectif 4 et 5. L'ensemble constitue une sorte de chargeur du genre de ceux qu'on utilise dans les nombreuses applications de la technologie par cassette.

Des moyens connus non représentés permettent de faire tourner la bobine 2 dans le sens indiqué par la flèche 6, et la bobine 3 dans le sens indiqué par la flèche 7.

Sur la bobine 2, ou bobine d'alimentation, se trouve enroulée une bande 8 sur laquelle sont placées les unes à la suite des autres les pièces à métalliser.

A sa sortie de la bobine 2, la bande 8 circule suivant la direction indiquée par la flèche 9. Elle passe alors successivement :

- sur un premier galet de renvoi 10 ;

- à travers un poste de métallisation sous vide désigné par la référence générale 11 ;

- autour d'un second galet de renvoi 12.

Ensuite, la bande 8 vient finalement s'enrouler sur la bobine de stockage 3.

Suivant un mode de réalisation préféré de l'invention, les galets 10 et 12 sont pourvus d'un moyen d'entraînement en rotation , ce qui permet de contrôler très exactement l'amplitude et la vitesse avec lesquelles la bande 8 circule à travers le poste de métallisation 11.

L'ensemble de l'espace intérieur à la cassette 1 est maintenu sous vide, à un niveau qui peut être par exemple compris entre $10^{-2}$ et $10^{-4}$ millimètres mercure.

Dans la zone du poste de métallisation 11, on entretient préférablement un vide plus poussé, par exemple égal à $10^{-6}$ millimètres de mercure.

Le poste comprend :

- un support fixe 13 placé immédiatement sous la partie correspondante de la bande 8 ;

- un masque fixe 14 est situé sur l'autre face de la bande 8 ;

- une anode fixe 15 est située au-delà du masque 14, si bien que celui-ci et la bande 8 passent entre l'anode 15 et le support 13.

L'anode 15 est réalisée en un métal qui est celui dont on prétend effectuer un dépôt sur certaines zones bien délimitées de la bande 8.

Le masque 14 comporte des zones pleines et des ouvertures découpées exactement suivant le contour qui délimite les zones à métalliser sur la bande 8.

La bande 8 est préférablement une bande métallique dans laquelle les pièces à métalliser sont découpées les unes à la suite des autres, si bien que lorsque la bande 8 circule de la bobine 2 à la bobine 3, les pièces défilent à travers le poste de métallisation sous vide 11.

Pour effectuer la métallisation, c'est-à-dire pour arracher du métal de l'anode 15 et venir l'appliquer sur les zones voulues de la bande 8, on établit entre l'anode 15 et la cathode 8, 13, une tension continue dont la valeur est par exemple comprise entre 1 500 volts et 7 000 volts. La valeur de cette tension est calculée en fonction de la nature des métaux en présence et de l'importance des surfaces à métalliser.

Enfin, les moyens non représentés prévus pour faire avancer la bande 8 à travers le poste de métallisation, confèrent à cette dernière un mouvement d'avancement saccadé, c'est-à-dire formé par une succession de phases d'avancement et de phases d'immobilité

L'ensemble du poste 11 qui vient d'être décrit constitue un poste de métallisation sous vide avec cathode à magnétron, qui fonctionne par l'application d'une haute tension continue, c'est-à-dire non pulsée.

Par contre, des moyens connus non représentés sont prévus pour établir ou interrompre cette haute tension en synchronisme avec les phases d'avancement ou d'immobilité de la bande 8.

Le fonctionnement est le suivant :

- pendant chaque phase d'avancement de la bande 8 (avec rotation des bobines 2 et 3, ainsi que des galets 10 et 12), aucune tension n'est appliquée entre l'anode et la catnode du poste 11.

Par contre, pendant chaque phase d'immobilité de la bande 8 (et par conséquent des bobines 2, 3 ainsi que des galets 10 et 12), la haute tension précitée est appliquée, si bien que des ions métalliques sont arrachés à l'anode 15 pour venir s'appliquer sur les zones à traiter de la bande 8 ou des pièces qu'elle porte.

Des moyens connus non représentés sont prévus pour ouvrir la "cassette" 1 et en retirer les bobines 2, 3 ainsi que la bande 8 dont elles sont équipées, pour chaque opération de mise en place d'une nouvelle bande 8, ou de récupération d'une bande 8 traitée.

On voit que l'installation et le procédé selon l' invention présentent le grand avantage d'effectuer une métallisation des pièces de la bande 8 en procédant à la fois de façon continue et de manière sélective (c'est-à-dire en ne métallisant que les zones où cela est nécessaire).

3

REVENDICATIONS

1.- Dispositif pour effectuer à la continue une métallisation sélective sur des pièces industrielles, caractérisé en qu.'il comprend :

- une bande souple continue (8) sur laquelle les pièces à traiter sont disposées les unes à la suite des autres ;

- un bobine d'alimentation (2) sur laquelle est enroulée la bande (8) des pièces à traiter ;

- un poste de métallisation sous vide (11) avec cathode à magnétron à travers lequel peut circuler la bande (8) ;

- une bobine de stockage (3) sur laquelle vient s'enrouler la bande (8) après traitement ;

- une cassette étanche (1) contenant les deux bobines (2) et (3), la bande (8) et le poste de métallisation (11) avec cathode à magnétron ;

- les moyens pour maintenir à l'intérieur de la cassette (1) un vide inférieur à 1/10 de millimètre de mercure ;

- des moyens pour entraîner en rotation les deux bobines (2) et (3) de façon à faire circuler la bande (8) à travers le poste de métallisation, en l'enroulant sur la bobine de stockage (3) tandis qu'elle se déroule de la bobine d'alimentation (2).

2.- Dispositif suivant la revendication 1, caractérisé en ce que le poste de métallisation (11) comporte une anode métallique(15)formée du métal à déposer sur les pièces, la bande (8) défilant entre cette anode(15) et une cathode(8), (13) entre lesquelles règne une tension électrique continue, un masque (14) découpé selon le contour à métalliser étant intercalé entre la bande (8) et l'anode (15).

3.- Dispositif suivant l'une quelconque des revendications précédentes, caractérisé en ce que la bande souple (8) est métallique, les pièces à métalliser étant directement découpées dans le métal de la bande (8)tout en restant liées les unes aux autres.

4.- Dispositif suivant l'une quelconque des redications précédentes,caractérisé en ce que les moyens pré-

0157991

vus pour l'entraînement des deux bobines (2) et (3) leur communiquent un mouvement saccadé, synchronisé avec les moyens créant la tension électrique entre l'anode (15) et la cathode (8), (13), à savoir :

    - la tension électrique du magnétron est coupée pendant chaque phase d'avancement de la bande (8) par rotation des bobines (2) et (3) ;

    - au contraire, cette tension est rétablie pendant chaque phase d'arrêt de la bande (8) et des bobines (2) et (3).

    5.- Dispositif suivant l'une quelconque des revendications précédentes, caractérisé en ce que l'ensemble de l'espace intérieur de la cassette (1) est maintenu sous vide, à un niveau compris entre $10^{-2}$ et $10^{-4}$ millimètres de mercure.

    6.- Dispositif suivant la revendication 5, caractérisé en ce que dans la zone du poste de métallisation (11) on entretient un vide plus poussé, de l'ordre de $10^{-6}$ millimètres de mercure.

    7.- Dispositif suivant l'une quelconque des revendications précédentes, caractérisé en ce que pour effectuer la métallisation, c'est-à-dire pour arracher du métal de l'anode (15) et venir l'appliquer sur les zones voulues de la bande (8), on établit entre l'anode (15) et la cathode (8), (13) une tension continue dont la valeur est comprise entre 1 500 volts et 7 000 volts.

FIG 1

B-5049 EP

PL.Unique

0157991

Office européen
des brevets

**RAPPORT DE RECHERCHE EUROPEENNE**

**0157991**
Numéro de la demande

EP 84 81 0175

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | US-A-4 278 528 (M.R. KUEHNLE)<br>* Figures 1,3,4; colonne 8, lignes 7-35 * | 1,2 | C 23 C 14/56 //<br>C 23 C 14/34 |
| Y | US-A-3 121 499 (L. TASSARA)<br>* Figure 2 * | 1 | |
| Y | US-A-4 303 489 (C.F. MORRISON)<br>* Colonne 3, lignes 61-68; colonne 4, lignes 1-29, 62-65 * | 1,2,4 | |
| Y | FR-A-2 335 615 (COULTER INFORMATION)<br>* Figure 9 * | 1 | |
| A | US-A-4 130 933 (C.J. DEMRICK)<br>* Figures 1,2 * | 3 | **DOMAINES TECHNIQUES RECHERCHES (Int. Cl.4)** |
| A | US-A-3 968 018 (G.C. LANE)<br>* Colonne 6, lignes 28-68; colonne 7, lignes 1-15 * | 4 | C 23 C 14/00 |
| A | THIN SOLID FILMS, vol. 52, no. 1, 1978, pages 31-43; K. WASA: "Some features of magnetron sputtering"<br>* Pages 31-33 * | 6 | |

--- -/-

Le présent rapport de recherche a été établi pour toutes les revendications

| Lieu de la recherche<br>LA HAYE | Date d'achèvement de la recherche<br>14-12-1984 | Examinateur<br>DEVISME F.R. |
|---|---|---|

Office européen
des brevets

**RAPPORT DE RECHERCHE EUROPEENNE**

0157991
Numéro de la demande

EP 84 81 0175

| | **DOCUMENTS CONSIDERES COMME PERTINENTS** | | Page 2 |
|---|---|---|---|
| Catégorie | Citation du document avec indication, en cas de besoin, des parties pertinentes | Revendication concernée | CLASSEMENT DE LA DEMANDE (Int. Cl.4) |
| A | JOURNAL OF VACUUM SCIENCE AND TECHNOLOGY, vol. 13, no. 1, 1976, pages 157-164; R.W. WILSON: "Application of high-rate ExBor magnetron sputtering in the metallization of semiconductor devices" * Pages 158,159, figure 2 * <br><br>--- | 7 | |
| A | INSTRUMENTS AND EXPERIMENTAL TECHNIQUES, vol. 23, no. 5, pt. 2, 1980, pages 1302-1303; A.V. AMOSOV: "Attachment to vacuum system for depositing coatings on strip" <br><br>----- | | |
| | | | **DOMAINES TECHNIQUES RECHERCHES (Int. Cl.4)** |

Le présent rapport de recherche a été établi pour toutes les revendications

| Lieu de la recherche | Date d'achèvement de la recherche | Examinateur |
|---|---|---|
| LA HAYE | 14-12-1984 | DEVISME F.R. |